# EUROPÄISCHE PATENTSCHRIFT

(11) **EP 0 971 408 B1**
(45) Veröffentlichungstag und Bekanntmachung des Hinweises auf die Patenterteilung: **17.09.2003**
(21) Anmeldenummer: 99112481.9
(22) Anmeldetag: 01.07.1999
(51) Int. Cl.: H01L 23/40, H01L 25/11, H01L 23/473

(54) **Formteil zur Halterung von Kühlkörpern in einem Spannstapel**
Molded Part Holding a Heatsink in a Press Stack
Pièce moulée pour tenir des dissipateurs de chaleur dans un épilement pressé

(30) Priorität: 08.07.1998 DE 19830424
(43) Veröffentlichungstag der Anmeldung: 12.01.2000
(73) Patentinhaber: ABB Schweiz AG, 5400 Baden (CH)
(72) Erfinder: Keller, Thomas, 5071 Gipf-Oberfrick (CH); Stemmler, Christoph, 5401 Baden (CH); Hildbrand, Urs, 8004 Zürich (CH)
(74) Vertreter: ABB Patent Attorneys

(56) Entgegenhaltungen:
- EP-A- 0 142 678
- FR-A- 2 751 132
- GRUENING H E ET AL: "HIGH PERFORMANCE LOW COST MVA INVERTERS REALISED WITH INTEGRATED GATE COMMUTATED THYRISTORS (IGCT)" EPE '97. 7TH. EUROPEAN CONFERENCE ON POWER ELECTRONICS AND APPLICATIONS. TRONDHEIM, SEPT. 8 - 10, 1997, EPE. EUROPEAN CONFERENCE ON POWER ELECTRONICS AND APPLICATIONS, BRUSSELS, EPE ASSOCIATION, B, Bd. 2 CONF. 7, 8. September 1997 (1997-09-08), Seiten 2060-2065, XP000778159 ISBN: 90-75815-02-6
- PATENT ABSTRACTS OF JAPAN vol. 008, no. 239 (E-276), 2. November 1984 (1984-11-02) & JP 59 119858 A (TOSHIBA KK), 11. Juli 1984 (1984-07-11)

## Beschreibung

### TECHNISCHES GEBIET

Die vorliegende Erfindung bezieht sich auf das Gebiet der Leistungshalbleitertechnik. Sie betrifft eine Halterung für Kühlkörper nach dem Oberbegriff des Patentanspruches 1, zur vorzugsweisen Verwendung in einem Halbleiter-Spannstapel, insbesondere für Hochleistungs-Stromrichter. Ein solcher Halbleiter-Spannstapel ist z.B. aus der Druckschrift P. Steimer et al. "Serieschaltung von GTO-Thyristoren für Frequenzumrichter hoher Leistung", ABB Technik 5 (1996), S. 14-20 bekannt.

### STAND DER TECHNIK

Bei bekannten wassergekühlten Stromrichtern hoher Leistung wird eine Mehrzahl von Leistungshalbleiterbauelementen (LHE) in einer Serieschaltung alternierend mit wasserdurchflossenen Kühldosen zu einem Stapel vereint. Die notwendigen elektrischen und thermischen Eigenschaften werden durch mechanisches Verspannen mittels Zugstangen erreicht. Zum Auswechseln eines defekten LHE wird der Spannstapel entspannt, wobei sämtliche Komponenten weiterhin in ihrer stapelachsenzentrierten Position gehalten werden müssen.

Die EP-A-0 142 678 zeigt einen Stromrichter mit einer Mehrzahl von LHEs in einer Serienschaltung alternierend mit Kühlkörpers.

Für die Halterung und Zentrierung der Kühldosen und der Leistungshalbleiterbauelemente sowie zur Fixierung der Kühlwasserzuleitung, der Kühlwasserableitung, der Speise- und Steuerkabel ist eine Vielzahl von Kunststoffteilen vorgesehen. Diese separaten Halterungen erfordern einen erhöhten Montageaufwand und sind einem schnellen Auswechseln einzelner Komponenten nicht dienlich.

Bei der neuesten Generation von Leistungshalbleiterschaltern ist ein in einem Presspack-Gehäuse untergebrachter GTO-Thyristor mit einer Platine verbunden, auf welcher auch die zugehörige Ansteuereinheit angeordnet ist. LHE und Ansteuerung bilden also eine Einheit (siehe obengenannte Druckschrift, Bild 5). Zur Verbesserung der mechanischen Stabilität muss, infolge des Gewichts der Ansteuereinheit, diese respektive die sie tragende Platine ebenfalls gestützt werden.

### DARSTELLUNG DER ERFINDUNG

Es ist Aufgabe der Erfindung, eine Vorrichtung zur Halterung von Komponenten eines Halbleiter-Spannstapels zu schaffen, welche sich durch einen deutlich vereinfachten und kompakteren Aufbau auszeichnet und ein rasches und einfaches Auswechseln einzelner Leistungshalbleiterbauelemente (LHE) erlaubt.

Die Aufgabe wird gelöst durch ein neues Formteil zur gleichzeitigen Halterung und Zentrierung eines Kühlkörpers sowie eines dazu unmittelbar benachbarten LHE. Dadurch wird eine neue Basiseinheit geschaffen, bestehend aus dem erfindungsgemässen Formteil, einem LHE und einem Kühlkörper, welche maximale Flexibilität beim Aufbau eines mehrkomponentigen Spannstapels offeriert. Das LHE und der Kühlkörper werden so positioniert, dass eine Elektrode des LHE und eine Kühlfläche des Kühlkörpers einander deckungsgleich gegenüberliegen. Beim Verspannen des Stapels werden jeweils eine Elektrode und eine Kühlfläche aufeinandergepresst, wodurch die thermische und elektrische Leitfähigkeit zwischen den Komponenten des Stapels optimiert wird.

Eine erste bevorzugte Ausführungsform ist dadurch gekennzeichnet, dass sowohl der Kühlkörper als auch das LHE durch einen einrastenden lösbaren Verschluss mit dem erfindungsgemässen Formteil verbunden sind. Dies erlaubt ein einfaches Auswechseln insbesondere des LHE, indem der entsprechende Verschluss als Folge einer hinreichenden Zugkraft auf das LHE dieses wieder freigibt.

Eine zweite bevorzugte Ausführungsform ist dadurch gekennzeichnet, dass zusätzlich zur stapelzentrierten Endposition der zwei Komponenten auch die Art und Weise bestimmt wird, wie diese Endposition zu erreichen ist. Die Erfindung sieht dazu die Existenz von Einbauhilfen für das LHE vor, welche Führungsmittel beim erfindungsgemässen Formteil sowie fest am LHE montierte Führungselemente umfassen. Letztere sind beispielsweise als Noppen oder Flügel ausgebildet und direkt mit dem LHE verbunden, sie werden durch ein entsprechendes zum Formteil gehöriges Gegenstück (Führungsmittel) in Form einer Schiene oder Rille geleitet.

Im Speziellen kann mittels dieser Führungsmittel beim Ausbau eines LHE aus dem Formteil das LHE so geführt werden, dass die Kontaktfläche des Kühlkörpers und die Elektrode des LHE nicht beschädigt werden. Dazu wird zuerst der ganze Stapel entspannt und die einzelnen, parallel zur Stapelachse beweglichen (weil beispielsweise durch die parallel zum Stapel verlaufenden Zugstangen geführten) Basiseinheiten etwas voneinander getrennt. Beim Ausbau aus der Halterung wird das LHE dank der Führungsmittel so verschoben, dass seine Elektrode schräg von der entsprechenden Kontaktfläche des Kühlkörpers getrennt wird und somit diese nicht zerkratzen kann. Dies wird auf einfache Art beispielsweise durch eine Führungsrille realisiert, welche nicht parallel zur Kontaktfläche des Kühlkörpers liegt.

Eine nächste bevorzugte Ausführungsform betrifft die Verwendung von LHE der eingangs beschriebenen Art, bei welchen der Halbleiter sich zusammen mit seiner Ansteuerung auf einer Platine befindet. In diesem Fall sind die Führungselemente nicht unmittelbar am LHE sondern an besagter Platine befestigt und dienen zusätzlich zur mechanischen Stützung der Ansteuereinheit. Gegebenenfalls kann die Platine selbst das Führungselement sein und direkt in entsprechende Führungsrillen eingeführt werden.

Weitere vorteilhafte Ausgestaltungen der Erfindung sind in den abhängigen Patentansprüchen definiert.

### KURZE ERLÄUTERUNG DER FIGUREN

Die Erfindung wird nachstehend anhand von Ausführungsbeispielen im Zusammenhang mit den Zeichnungen näher erläutert. Es zeigen :
- Fig. 1 :: perspektivische Ansicht eines Formteils nach der Erfindung, zusammen mit Teilen der Kühlvorrichtung
- Fig.2 :: idem, zusätzlich ist ein auf einer Platine montiertes Leistungshalbleiterbauelement gezeigt.
- Fig.3 :: Detail Einrast-Verschluss
- Fig.4 :: Detail Führungsrille

### WEGE ZUR AUSFÜHRUNG DER ERFINDUNG

In den Figuren sind gleiche Teile mit gleichen Bezugszeichen gekennzeichnet.

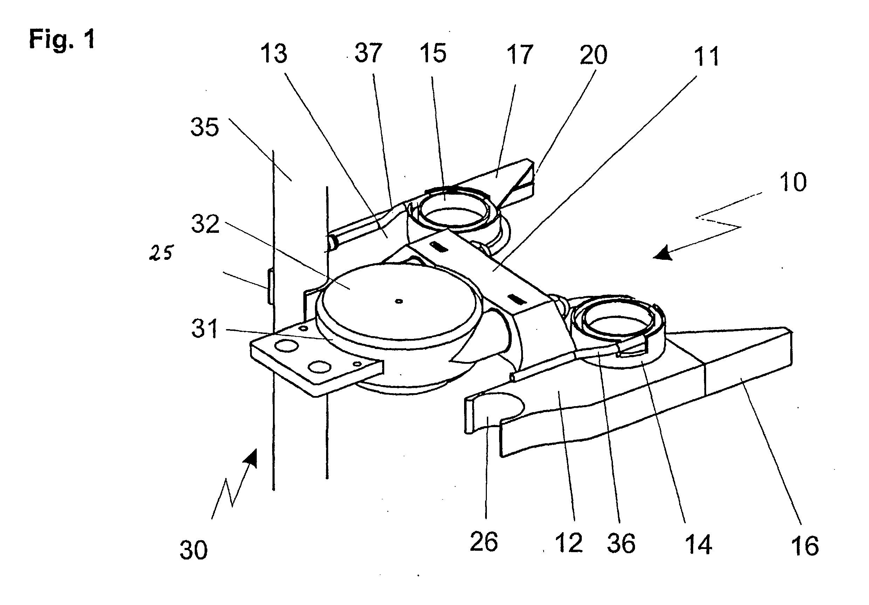

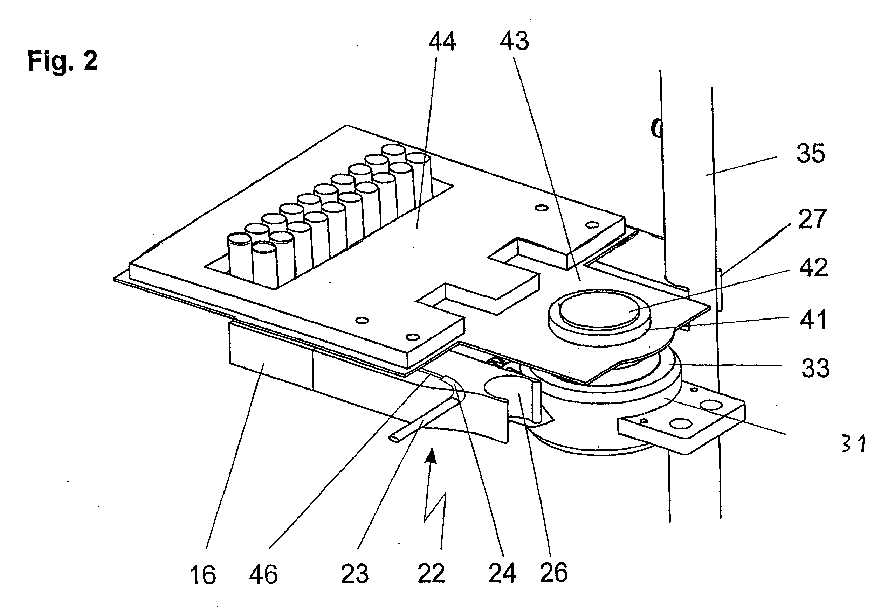

In Fig.1 und Fig.2 ist in perspektivischer Ansicht ein bevorzugtes Ausführungsbeispiel eines Formteils 10 nach der Erfindung zusammen mit einigen Komponenten der Kühlvorrichtung 30 wiedergegeben. In Fig.2 ist zusätzlich ein Leistungshalbleiterbauelement (LHE) 41 gezeigt, welches fest mit einer Platine 43 verbunden ist.

Die Kühlvorrichtung 30 umfasst eine wasserdurchspühlte Kühldose 31 welche an der entsprechenden Halterung 11 des erfindungsgemässen Formteils 10 montiert ist. Die Kühlwasserzu- und ableitungen 36,37 zwischen der Kühldose 31 und dem Kühlwasserverteilrohr (nicht gezeigt) sowie dem Kühlwassersammelrohr 35 müssen möglicherweise eine gewisse minimale Länge aufweisen. Dies deshalb, weil durch einen Potentialunterschied zwischen der Kühldose 31 und dem elektrisch leitenden Rohr 35 ein korrodierender Elektrolysestrom getrieben wird, welcher einen gewissen Wert nicht überschreiten darf. Um die notwendige Länge zu erreichen, können die Leitungen 36,37 spiralförmig ausgebildet sein. Ihre Halterungen 14,15 verhindern, dass sich zwei auf unterschiedlichem elektrostatischem Potential befindliche Punkte der Kühlwasserleitungen berühren.

Das LHE 41 ist in einem zylindrischen Gehäuse untergebracht, welches an beiden Stirnseiten zur elektrischen und thermischen Ankopplung mit flächigen, kreisrunden Elektroden 42 (Anoden, Kathoden) versehen ist. Im Halbleiterstapel ist jeweils auf beiden Seiten des LHE eine ebenfalls zylindrische Kühldose 31 derart angeordnet, dass deren Kontaktflächen 32,33 mit den Elektroden 42 des LHE in Kontakt kommen. Durch die Verwendung des erfindungsgemässen Formteils wird jeweils ein LHE mit einer benachbarten Kühldose paarweise kombiniert.

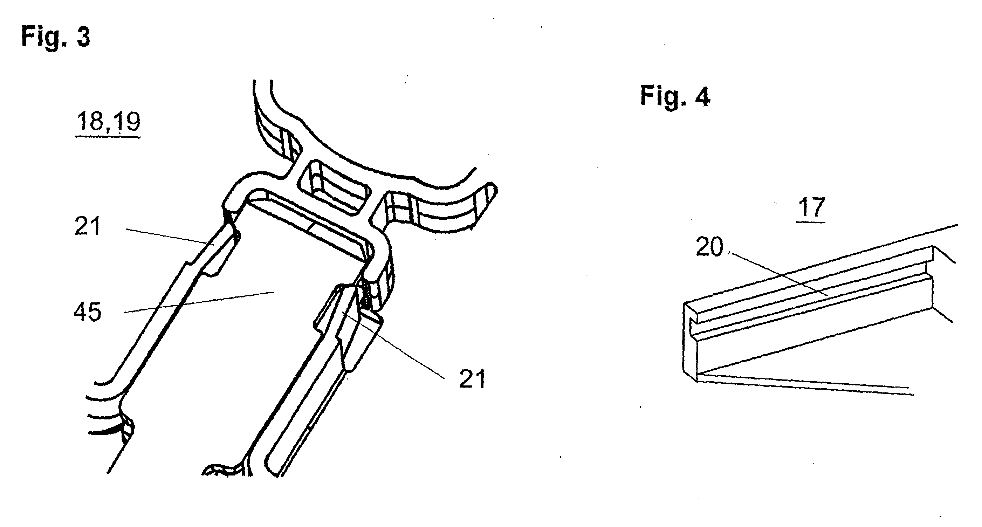

Beim in der Fig.2 dargestellten LHE 41 handelt es sich um einen mit einer Platine 43 fest verbundenen GTO Thyristor. Die Halterungen 12,13, welche für die korrekte.Positionierung des LHE 41 verantwortlich sind, greifen in diesem Fall nicht direkt am LHE 41 an. Zentraler Teil der Halterung 12,13 ist ein Einrast-Verschluss 18, 19, dessen Gegenstück 45 auf der Platine 43 montiert ist. Ein solcher Einrast-Verschluss ist in Fig. 3 dargestellt zusammen mit seinem Gegenstück 45, welches in den Verschluss eingeführt und von den zwei Laschen 21 festgehalten wird. Diese wiederum sind so dimensioniert, dass sie auf Zugbeanspruchung das Gegenstück 45 und somit das LHE 41 wieder freigeben.

Beim Einbau wird das LHE 41 nicht direkt, sondern mittels auf der Platine 43 montierter Führungselemente (nicht gezeigt) geführt. Die dafür zuständigen Führungsmittel 16,17 als Teil des Formteils 10 haben die Form flügelförmiger Erweiterungen. An ihrer Innenseite sind Führungsrillen 20 vorhanden, welche beim Einbau des LHE 41 die Platine 43 und somit auch das fest damit verbundene LHE führen (Fig. 4). Durch die Neigung dieser Rille wird das LHE derart bewegt, dass seine Elektrode 42 die Kontaktfläche 33 der Kühldose 31 erst bei Erreichen der Endposition berührt und zuvor jede Reibung zwischen den zwei Flächen 42,33 vermieden wird. Nach erfolgtem Einbau des LHE wird die Platine sowie die darauf befindliche Ansteuereinheit 44 durch die Führungsmittel 16,17 zusätzlich abgestützt und mechanisch stabilisiert.

Die erfindungsgemässe Vorrichtung ist aus elektrisch isolierendem Material, vorzugsweise Kunststoff, hergestellt und kann im Spritzgussverfahren kostengünstig produziert werden.

Falls auf der Platine 43 auch die Ansteuereinheit 44 enthalten ist, ergibt sich für das Auswechseln eines LHE 41 eine weitere Vereinfachung dadurch, dass auch die Kontaktvorrichtung 22 für die Speisung der Ansteuereinheit 44 in das Formteil 10 integriert wird. Das Speisekabel 23 wird vorzugsweise durch eine Aussparung im Formteil bis zu einer Buchse 24 geführt, welche fest im Formteil verankert ist. Ein Stecker 46 als deren Gegenstück befindet sich auf der Platine 43. Wird nun das LHE eingebaut, ensteht ein elektrischer Kontakt zwischen dem Speisekabel 23 und der Ansteuerung 44, sobald das LHE die stapelzentrierte Endposition erreicht. Somit muss beim Auswechseln eines LHE nur noch ein allfälliges Steuerkabel separat von der alten Ansteuereinheit abgehängt und an die Neue angehängt werden.

Zur Verwendung der erfindungsgemässen Formteile in einem Halbleiter-Spannstapel sind zusätzlich zu den genannten Merkmalen weitere vorteilhafte Ausführungsformen vorgesehen:

Die zum Verspannen des Stapels notwendigen Zugstangen verlaufen parallel zum Stapel. Im vorliegenden Beispiel sind sie als Rohre 35 ausgebildet und dienen gleichzeitig zum Verteilen und Sammeln des Kühlwassers. Daran werden nun ihrerseits die erfindungsgemässen Formteile so montiert, dass die von ihnen gehaltenen Komponenten im Stapel zentriert sind. In Fig.1 ist ersichtlich, wie ein Formteil am Kühlwassersammelrohr 35 mittels eines Clippverschlusses 25,26 angebracht wird. Dabei ist zu beachten, dass die Formteile in Richtung der Stapelachse nicht vollständig blockiert sind, da sie sich beim Spannen und Entspannen des Stapels noch verschieben können müssen. Dagegen muss der Clippverschluss 25,26 auf Zugkräfte in der Ebene senkrecht zum Stapel bzw. zum Kühlwasserrohr belastbar sein, d.h. er darf bei Zugbelastung keinesfalls früher als der Einrast-Verschluss 18,19 nachgeben.

Insgesamt ergibt sich unter Verwendung mehrerer erfindungsgemässer Formteile ein Halbleiterspannstapel, der sich durch einen vereinfachten Aufbau auszeichnet und eine erhöhte mechanische Stabilitat aufweist. Darüber hinaus wird das Auswechseln von defekten LHE vereinfacht, weil zu deren Führung und Halterung Schienen und einrastende Verschlüsse vorgesehen sind. Die erfindungsgemässe multifunktionelle Halterung kann als Spritzgussteil einfach und kostengünstig hergestellt werden.

### BEZEICHNUNGSLISTE

- 10: Erfindungsgemässes Formteil
- 11: Halterung der Kühldose
- 12, 13: Halterung des Halbleiters
- 14, 15: Halterung der Kühlwasserleitung
- 16, 17: Führungsmittel
- 18, 19: Einrast-Verschluss
- 20: Führungsrinne
- 21: Laschen
- 22: Kontaktvorrichtung
- 23: Speisekabel
- 24: Buchse
- 25, 26: Clipp-Verschluss
- 30: Kühlvorrichtung
- 31: Kühldose
- 32,33: Kontaktfläche
- 35: Kühlwassersammelrohr
- 36, 37: Kühlwasserleitung
- 41: Leistungshalbleiterbauelement (LHE)
- 42: Elektrode
- 43: Platine
- 44: Ansteuereinheit
- 45: Gegenstück Einrast-Verschluss
- 46: Stecker

## Patentansprüche

1. Formteil (10), umfassend erste Haltemittel (11) zur Halterung eines flüssigkeitsgekühlten Kühlkörpers (31), der mindestens eine Kontaktfläche (33) aufweist und der zur Kühlung mindestens eines Leistungshalbleiterbauelements (41) mit mindestens einer flächigen Elektrode (42) dient;
**dadurch gekennzeichnet, dass**
das Formteil zweite Haltemittel (12,13) zur Halterung des Leistungshalbleiterbauelements (41) umfasst,
welche zweite Haltemittel (12,13) zur Positionierung der Elektrode (42) des Leistungshalbleiterbauelements (41) im wesentlichen deckungsgleich neben der Kontaktfläche (33) des Kühlkörpers (31) dienen.

2. Formteil nach Anspruch 1, **dadurch gekennzeichnet, dass** die Haltemittel (12,13) mindestens einen einrastenden und wieder lösbaren Verschluss (18,19) aufweisen.

3. Formteil nach Anspruch 2, **dadurch gekennzeichnet, dass** Führungsmittel (16,17) vorgesehen sind zur Führung eines Führungselementes beim Einbau und Ausbau des damit verbundenen Leistungshalbleiterbauelements (41).

4. Formteil nach Anspruch 3, **dadurch gekennzeichnet, dass** die Führungsmittel (16,17) oder das Führungselement derart ausgebildet sind, dass beim Ausbau des Leistungshalbleiterbauelements (41) die Trennung der Elektrode (42) des Leistungshalbleiterbauelements von der Kontaktfläche (33) des Kühlkörpers (31) durch eine nicht vollständig in der Ebene der Kontaktfläche geführte Bewegung erfolgt.

5. Formteil nach Anspruch 4, **dadurch gekennzeichnet, dass** die Führungsmittel (16,17) Rillen oder Schienen (20) umfassen.

6. Formteil nach Anspruch 5, **dadurch gekennzeichnet, dass** das Führungselement eine Platine (43) ist, welche mit dem Leistungshalbleiterbauelement (41) verbunden ist.

7. Formteil nach Anspruch 6, **dadurch gekennzeichnet, dass** eine elektrische Kontaktvorrichtung (22) für die Speisung der zum Leistungshalbleiterbauelement (41) gehörigen Ansteuereinheit (44) vorgesehen ist, welche mit einem Speisekabel (23) verbunden ist und beim Einbau bzw. Ausbau des Leistungshalbleiterbauelementes mit der Ansteuereinheit in elektrische Wirkverbindung tritt oder diese unterbricht.

8. Formteil nach Anspruch 7, **dadurch gekennzeichnet, dass** dritte Haltemittel (14,15) zur Halterung mindestens einer Kühlflüssigkeitsleitung (36,37) vorgesehen sind.

9. Formteil nach einem der Ansprüche 1 - 8 ohne 7, **dadurch gekennzeichnet, dass** es aus einem im Spritzgussverfahren hergestellten Kunststoffkörper besteht.

10. Verwendung mindestens eines Formteiles nach einem der Ansprüche 1 - 9, zur Halterung und Zentrierung von Leistungshalbleiterbauelementen und Kühlkörpern in einem Halbleiter-Spannstapel, in welchem eine Mehrzahl von Leistungshalbleiterbauelementen zusammen mit flüssigkeitsgekühlten Kühlkörpern alternierend angeordnet sind, **dadurch gekennzeichnet, dass** das Formteil selbst mit mindestens einer parallel zum Spannstapel verlaufenden Stange (35) derart verbunden ist, dass das Formteil in Stapelrichtung beweglich bleibt.

## Claims

1. Moulding (10) comprising first holding means (11) for holding a liquid-cooled heat sink (31), which has at least one contact surface (33), and which is used for cooling at least one power semiconductor component (41) having at least one flat electrode (42); **characterized in that**
the moulding comprises second holding means (12, 13) for holding the power semiconductor component (41),
which second holding means (12, 13) serve to position the electrode (42) of the power semiconductor component (41) essentially such that it is superimposed alongside the contact surface (33) of the heat sink (31).

2. Moulding according to Claim 1, **characterized in that** the holding means (12, 13) have at least one fastener (18, 19) which latches in and can be detached again.

3. Moulding according to Claim 2, **characterized in that** guide means (16, 17) are provided for guiding a guide element during installation and removal of the power semiconductor component (41) which is connected to it.

4. Moulding according to Claim 3, **characterized in that** the guide means (16, 17) or the guide element are/is designed in such a manner that, during removal of the power semiconductor component (41), the electrode (42) of the power semiconductor component is disconnected from the contact surface (33) of the heat sink (31) by a guided movement which is not entirely in the plane of the contact surface.

5. Moulding according to Claim 4, **characterized in that** the guide means (16, 17) comprise grooves or rails (20).

6. Moulding according to Claim 5, **characterized in that** the guide element is a board (43), which is connected to the power semiconductor component (41).

7. Moulding according to Claim 6, **characterized in that** an electrical contact apparatus (22) is provided for supplying the drive unit (44) which is associated with the power semiconductor component (41), is connected to a supply cable (23) and makes an electrical operative connection with the drive unit, or interrupts this connection, respectively, during installation and, respectively, removal of the power semiconductor component.

8. Moulding according to Claim 7, **characterized in that** third holding means (14, 15) are provided for holding at least one cooling liquid line (36, 37).

9. Moulding according to one of Claims 1-8, excluding 7, **characterized in that** the said moulding comprises a plastic body produced using the injection-moulding process.

10. Use of at least one moulding according to one of Claims 1-9, for holding and centring power semiconductor components and heat sinks in a semiconductor clamped stack, in which a plurality of power semiconductor components are arranged alternately together with liquid-cooled heat sinks, **characterized in that** the moulding itself is connected to at least one rod (35), which runs parallel to the clamped stack, in such a manner that the moulding remains movable in the stack direction.

## Revendications

1. Pièce moulée (10), comprenant des premiers moyens supports (11) pour tenir un dissipateur de chaleur (31) refroidi par liquide, lequel présente au moins une surface de contact (33) et sert à refroidir au moins un composant semiconducteur de puissance (41) comprenant au moins . une électrode plane (42), **caractérisée en ce que** la pièce moulée comprend des deuxièmes moyens supports (12, 13) pour tenir le composant semiconducteur de puissance (41), lesquels deuxièmes moyens supports (12, 13) servent à positionner l'électrode (42) du composant semiconducteur de puissance (41) pour l'essentiel en coïncidence à côté de la surface de contact (33) du dissipateur de chaleur (31).

2. Pièce moulée selon la revendication 1, **caractérisée en ce que** les moyens supports (12, 13) présentent au moins un verrou (18, 19) qui s'encliquette et qui peut à nouveau se libérer.

3. Pièce moulée selon la revendication 2, **caractérisée en ce que** des moyens de guidage (16, 17) sont prévus pour guider un élément de guidage lors du montage et démontage du composant semiconducteur de puissance (41) qui y est attaché.

4. Pièce moulée selon la revendication 3, **caractérisée en ce que** les moyens de guidage (16, 17) ou l'élément de guidage sont configurés de manière à ce que lors du démontage du composant semiconducteur de puissance (41), la séparation de l'électrode (42) du composant semiconducteur de puissance de la surface de contact (33) du dissipateur de chaleur (31) s'effectue par un mouvement qui n'est pas entièrement effectué dans le plan de la surface de contact.

5. Pièce moulée selon la revendication 4, **caractérisée en ce que** les moyens de guidage (16, 17) comprennent des rainures ou des glissières (20).

6. Pièce moulée selon la revendication 5, **caractérisée en ce que** l'élément de guidage est une platine (43) qui est reliée au composant semiconducteur de puissance (41).

7. Pièce moulée selon la revendication 6, **caractérisée en ce qu'**il est prévu un dispositif de contact électrique (22) pour l'alimentation du module de commande (44) faisant partie du composant semiconducteur de puissance (41), lequel est relié à un câble d'alimentation (23) et établit ou interrompt la liaison électrique active du composant semiconducteur de puissance avec le module de commande lors du montage ou du démontage de celui-ci.

8. Pièce moulée selon la revendication 7, **caractérisée en ce que** sont prévus des troisièmes moyens supports (14, 15) pour tenir au moins une conduite de liquide de refroidissement (36, 37).

9. Pièce moulée selon l'une des revendications 1 à 8, à l'exclusion de la 7, **caractérisée en ce qu'**elle est composée d'un élément en matière plastique fabriqué selon le procédé du moulage par injection.

10. Utilisation d'au moins une pièce moulée selon l'une des revendications 1 à 9 pour tenir et centrer des composants semiconducteurs de puissance et des dissipateurs de chaleur dans un empilement pressé de semiconducteurs dans lequel plusieurs composants semiconducteurs de puissance sont regroupés en alternance avec des dissipateurs de chaleur refroidis par liquide, **caractérisée en ce que** la pièce moulée elle-même est reliée avec au moins une tige (35) qui s'étend parallèlement à l'empilement pressé de telle manière que la pièce moulée reste mobile dans le sens de l'empilement.
